Europäisches Patentamt

(19) European Patent Office

Office européen des brevets

(11) Numéro de publication: **0 046 107**
**B1**

(12) FASCICULE DE BREVET EUROPEEN

(45) Date de publication du fascicule du brevet:
21.09.83

(21) Numéro de dépôt: **81401235.7**

(22) Date de dépôt: **30.07.81**

(51) Int. Cl.³: **H 01 L 23/56**

(54) **Dispositif semiconducteur utilisable en très haute fréquence, et son procédé de fabrication.**

(30) Priorité: **08.08.80 FR 8017533**

(43) Date de publication de la demande:
**17.02.82 Bulletin 82/7**

(45) Mention de la délivrance du brevet:
**21.09.83 Bulletin 83/38**

(84) Etats contractants désignés:
**DE GB NL**

(56) Documents cités:
**FR-A-2 277 459**
**FR-A-2 447 609**
**GB-A-1 353 310**

(73) Titulaire: **THOMSON-CSF, 173, Boulevard Haussmann,
F-75379 Paris Cedex 08 (FR)**

(72) Inventeur: **Henry, Raymond, THOMSON-CSF
SCPI 173, bld Haussmann, F-75360 Paris Cedex 08 (FR)**
Inventeur: **Heitzmann, Michel, THOMSON-CSF
SCPI 173, bld Haussmann, F-75360 Paris Cedex 08 (FR)**

(74) Mandataire: **Taboureau, James, THOMSON-CSF
SCPI 173, Bld Haussmann, F-75379 Paris Cedex 08 (FR)**

Dispositif semiconducteur utilisable en très haute fréquence, et son procédé de fabrication

L'invention concerne un procédé de fabrication d'un dispositif semiconducteur utilisable en très haute fréquence et dont la valeur de l'impédance peut être préréglée au cours de sa fabrication.

On connaît par la demande de brevet FR-A-2 447 609 de la demanderesse un dispositif semiconducteur utilisable en très haute fréquence dans lequel un anneau cylindrique de matériau diélectrique, à faces planes métallisées, est disposé autour d'une diode de type Gunn ou avalanche. Cet anneau est soudé par l'une de ses faces métallisées à un support métallique auquel est raccordée électriquement et thermiquement une base élargie de la diode. Un tronçon de fibre métallisé est introduit dans l'anneau et sert à établir un contact de polarisation de la diode avec l'autre face métallisée de l'anneau.

Le montage précédent permet de constituer une cavité radiale transformatrice d'impédance. Toutefois il ne peut être ajusté facilement à une valeur d'impédance prédéterminée ce qui présente un inconvénient dans l'application de ce dispositif. D'autre part, les très faibles dimensions du tronçon de fibre, notamment celle de sa longueur, rendent sa réalisation malaisée.

C'est pour remédier aux inconvénients précédents que l'on expose dans le cadre de la présente invention un procédé de fabrication d'un dispositif pouvant fonctionner à très haute fréquence comportant une ligne coaxiale dont l'impédance peut être préréglée au cours de sa fabrication. Cette invention a également pour but d'apporter des perfectionnements à la structure du dispositif pour rendre sa fabrication plus aisée et d'offrir une plus grande latitude pour ajouter des circuits du genre: microstrip, antenne rayonnante ou cavité radiale.

Le procédé de fabrication d'un dispositif semiconducteur utilisable en très haute fréquence comportant une ligne coaxiale à impédance préréglable, comprend conformément à l'invention les étapes succesives suivantes:

– fabrication de n diodes utilisables en très haute fréquence fixées sur une plaquette commune;
– préparation de n anneaux cylindriques en matériau diélectrique, comportant au moins une extrémité plane qui est métallisée;
– préparation de n mandrins cylindriques comportant au moins une couche cylindrique en métal bon conducteur d'électricité, mandrins dont le diamètre extérieur est inférieur au diamètre interne des anneaux;
– métallisation de la paroi cylindrique extérieure des anneaux et au moins de l'une de ces faces d'extrémités;
– formation sur les n mandrins d'une extrémité bombée et d'une extrémité opposée plane;
– métallisation des surfaces d'extrémités des mandrins;
– on entoure chaque diode par un desdits anneaux et on soude les anneaux par leur face métallisée à la plaquette commune;
– introduction des n mandrins dans les n anneaux en plaçant les extrémités bombées métallisées aux contacts des diodes;
– obturation hermétique des intervalles entre les mandrins et les anneaux par un joint de résine thermodurcissable;
– découpage de la plaquette en semelles individuelles supportant chacune une diode entourée par un anneau et contactée par un mandrin, métallisés tous les deux comme il est expliqué précédemment.

Le dispositif semiconducteur selon l'invention comprend une diode du type fonctionnant à très haute fréquence et une ligne coaxiale à impédance préréglable constituée par: un anneau cylindrique, concentrique à la diode, de diamètres interne d1 et externe d2, de longueur h prédéterminée, en matériau diélectrique, comportant sur sa surface cylindrique extérieure et sur l'une de ses extrémités au moins une couche métallique; un mandrin cylindrique de diamètre extérieur qui est inférieur au diamètre d1, de longueur L au moins égale à la longueur h de l'anneau, mandrin comportant une extrémité bombée et une extrémité opposée plane, ce mandrin comportant au moins une couche cylindrique métallique bonne conductrice d'électricité.

Les objets et caractéristiques de la présente invention apparaîtront plus clairement à la lecture de la description suivante d'exemples de réalisation, ladite description étant faite en relation avec les dessins ci-annexés dans lesquels:

La figure 1 représente une vue en coupe d'un support de diode portant une diode et pouvant être utilisé au départ du procédé selon l'invention.

La figure 2 représente une vue en coupe d'un anneau du dispositif semiconducteur selon l'invention.

La figure 3 représente une vue en coupe d'un mandrin du dispositif selon l'invention.

La figure 4 représente en coupe un mode de réalisation préféré d'un dispositif semiconducteur selon l'invention.

Le procédé de fabrication du dispositif semiconducteur selon la présente invention vise avant tout à la réalisation d'une ligne coaxiale d'impédance préréglée, de dimensions extrêmement réduites, et qui est couplée à une diode utilisable en haute fréquence de façon à l'encapsuler hermétiquement.

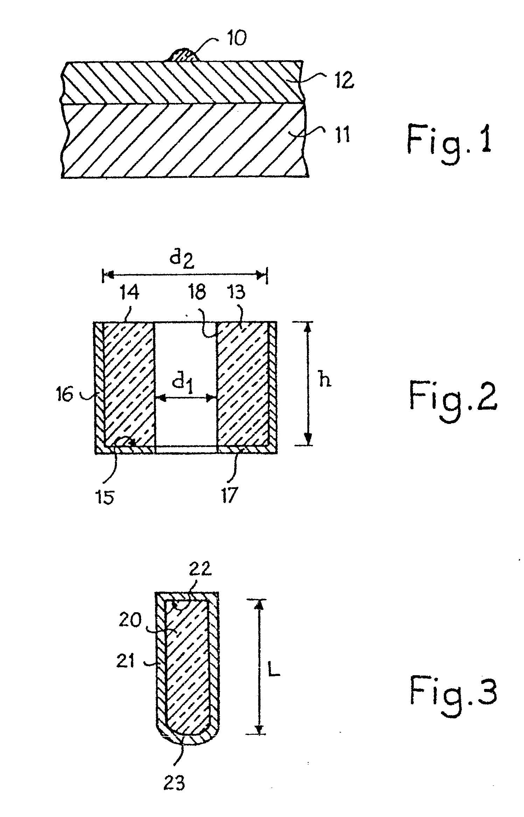

Pour réaliser le dispositif semiconducteur selon l'invention on part d'une diode 10 utilisable en très haute fréquence par exemple d'une diode Gunn ou d'une diode à avalanche. Une étape préliminaire au procédé selon l'invention, représentée par la figure 1, consiste à réaliser sur un support 11 métallique recouvert d'une plaquette 12 d'or, par une attaque chimique convenable, plusieurs diodes ayant une forme de «mesa», et ensuite de séparer le support 11 de la plaquette 12 portant la diode 10, celle-ci restant fixée à la plaquette 12 d'or.

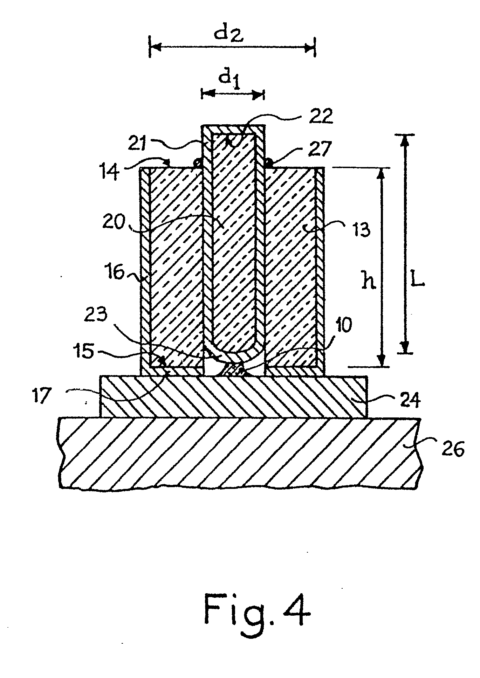

Au départ du procédé selon l'invention représenté par la figure 2, on commence par préparer des anneaux 13 en matériau diélectrique de forme cylindrique, et comportant deux faces terminales 14 et 15 qui sont de préférence façonnées planes et parallèles entre elles.

On recouvre ensuite la surface extérieure cylindrique des anneaux 13 par au moins une couche 16 métallique. En même temps ou séparément on dépose sur la face 15 des anneaux 13 au moins une couche 17 métallisée. De préférence on dépose par évaporation successive une couche de titane puis une couche d'or l'épaisseur totale étant comprise entre 1 et plusieurs microns. Ces couches de métaux servent à former le conducteur cylindrique extérieur 16 de la structure d'une ligne coaxile permettant le réglage de l'impédance du dispositif semiconducteur recherché ainsi que la couche 17 servant à souder l'anneau 13 à la plaquette 12. Les anneaux 13 s'obtiennent par exemple en tronçonnant des tubes de verre calibrés ayant un diamètre intérieur d1 compris entre 120 et 130 microns et un diamètre extérieur d2 voisin de 1000 microns. On coupe de préférence en tronçons un tube en verre dont la constante diélectrique relative ε est égale ou voisine de: 6.

Au stade suivant du procédé on place chaque anneau 13 autour d'une diode 10 de manière à entourer celle-ci par sa paroi 18 interne cylindrique. La face métallisée 15 est ensuite soudée à la plaquette 12 au moyen d'une soudure tendre de type indium-étain pour éviter au mieux les éventuelles contraintes mécaniques.

L'étape suivante montrée par la figure 3 concerne la fabrication du conducteur central de la ligne coaxiale qui sera couplée à une diode 10.

Ce conducteur est formé par exemple par dépôt d'une ou plusieurs couches 21 de métaux sur la surface d'un mandrin 20 en matériau diélectrique. Ce mandrin peut être constitué d'un tronçon de fibre de verre optique. Sa longueur L est alors prévue légèrement supérieure à la longueur h de l'anneau précédent et il comporte une extrémité bombée 23 et une extrémité 22 opposée plane. Le diamètre de ce mandrin doit être légèrement inférieur à celui du passage central de l'anneau 13 de manière à ce qu'après une métallisation du mandrin celui-ci puisse être inséré dans ce passage.

L'extrémité 23 bombée du mandrin est réalisée par une microfusion du verre suivie de son refroidissement. Elle est ensuite métallisée. Le bombage permet de faciliter par la suite la prise de contact du mandrin avec le sommet de la diode 10 déjà soudée par sa base à la plaquette 12 d'or.

A la place d'un tel tronçon de verre métallisé on pourrait utiliser par exemple comme conducteur central un mandrin 20 formé d'un tronçon de fil métallique bon conducteur d'électricité dont le diamètre est inférieur au passage central de l'anneau 13.

Un bon contact avec la diode peut être assuré par une thermocompression ou une microbrasure entre le contact ohmique du sommet de la diode 10 et l'extrémité 23 bombée métallisée. Le métal déposé sur cette dernière est de préférence de l'or. Dans le cas d'un mandrin en verre on dépose l'or sur une sous-couche de titane préalablement déposée sur la surface de verre.

Une fois introduit dans le passage central de l'anneau le mandrin 20 agit à la manière d'un bouchon. Ce montage est représenté par la figure 4. L'intervalle entre anneau et mandrin est ensuite obturé hermétiquement par des moyens convenables par exemple par un joint de résine thermodurcissable 27 reliant le mandrin 20 au bord contigu de l'extrémité 14 plane de l'anneau 13.

L'opération suivante consiste à séparer les dispositifs semiconducteurs ainsi encapsulés au cours des opérations précédentes par un découpage convenable de la plaquette 12 en semelles 24 individuelles portant chacune un dispositif. Cependant au lieu de découper la plaquette 12 à ce stade de fabrication on aurait pu la découper en semelles individuelles avant le début de l'opération de soudure des anneaux 13, et puis appliquer le processus précédent. La méthode préconisée à l'avantage de mieux s'adapter à une production de masse donc d'être plus industrielle.

Chacun des dispositifs individuels est alors soudé par l'intermédiaire de la semelle 24 sur un support métallique 26 (par exemple un support classique à vis) au moyen d'une soudure convenable. L'ensemble du dispositif est terminé selon les pratiques habituelles lui conférant protection et moyens de connexion extérieure.

La ligne coaxiale constituée par les couches 16 et 21 métalliques à une valeur d'impédance Z qui est égale à peu près à:

$$\frac{138}{\sqrt{\varepsilon}} \, \mathrm{Log} \left(\frac{d2}{d1}\right).$$

Cette valeur Z peut donc être modifiée simplement 30 en changeant des trois variables d1, d2 et ε.

A titre d'exemple si l'on choisit: ε = 6, d1 = 125 microns, d2 = 1000 microns, on obtiendra une valeur d'impédance Z voisine de 50 ohms.

La longueur h du tronçon de ligne coaxiale pourra être comprise entre 1,23 et 1,8 mm pour des fréquences de fonctionnement voisines de 100 GHz.

**Revendications**

1. Procédé de fabrication d'un dispositif semiconducteur utilisable en très haute fréquence comportant une ligne coaxiale à impédance préréglable et comprenant:

– fabrication de n diodes (10) utilisables en très haute fréquence fixées sur une plaquette commune (12);
– préparation de n anneaux (13) cylindriques en matériau diélectrique, comportant deux faces terminales (14, 15) planes;

– préparation de n mandrins (20) cylindriques, dont le diamètre extérieur (d2) est inférieur au diamètre interne (d1) des anneaux (13) et dont la longueur L est au moins égale à la longueur h des anneaux (13), ce procédé étant caractérisé en ce qu'il comporte en outre les étapes suivantes:

– métallisation (16) de la paroi cylindrique extérieure des anneaux (13), et d'une face terminale (15);

– formation sur les n mandrins (20) d'une extrémité bombée (23) et d'une extrémité opposée (22) plane;

– métallisation des surfaces (21, 22, 23) des mandrins (20);

– dépôt d'un anneau (13) autour de chaque diode (10) et soudure des anneaux par leur face (17) métallisée à la plaquette (12) commune;

– introduction des n mandrins (20) dans les n anneaux (13), en plaçant les extrémités bombées (23) métallisées au contact des diodes (10);

– obturation hermétique des intervalles entre les mandrins (20) et les anneaux (13) par un joint de résine thermidurcissable (27);

– découpage de la plaquette (12) en semelles (24) individuelles supportant chacune une diode (10) entourée par un anneau (13) et contactée par un mandrin (20);

– montage de chaque semelle (24) sur un support (26) métallique par soudure.

2. Procédé selon la revendication 1, caractérisé en ce que le mandrin (20) est constitué par un tronçon de fil métallique bon conducteur d'électricité.

3. Procédé selon la revendication 1, caractérisé en ce que le mandrin (20) est un tronçon de fibre de verre métallisé.

4. Procédé selon la revendication 1, caractérisé en ce que l'anneau (13) est un tronçon de tube de verre.

5. Procédé selon la revendication 4, caractérisé en ce que le verre est du type à constante diélectrique ε égale ou voisine de: 6.

6. Procédé selon l'une quelconque des revendications 1 à 5, caractérisé en ce que d1 et d2 sont respectivement sensiblement égaux à 125 et 1000 microns et en ce que h est compris entre 1,23 et 1,8 mm pour des fréquences de fonctionnement de l'ordre de 100 GHz.

**Ansprüche**

1. Verfahren zur Herstellung eines Halbleiterbauteils, das bei sehr hohen Frequenzen verwendbar ist und eine Koaxialleitung mit voreinstellbarer Impedanz besitzt, wobei das Verfahren enthält

– die Herstellung von n Dioden (10), die bei sehr hohen Frequenzen verwendbar sind und auf einer gemeinsamen Platte (12) befestigt sind;

– die Vorbereitung von n zylindrischen Ringen (13) aus dielektrischem Material und mit zwei ebenen Endflächen (14, 15);

– die Vorbereitung von n zylindrischen Stempeln (20), deren Aussendurchmesser (d2) geringer als der Innendurchmesser (d1) der Ringe (13) und deren Länge L mindestens gleich der Länge h der Ringe (13) gewählt ist, dadurch gekennzeichnet, dass das Verfahren ausserdem folgende Schritte aufweist:

– Metallisierung (16) der zylindrischen Aussenwand der Ringe (13) und einer der Endflächen (15);

– Ausbildung einer Stirnfläche (23) der n Stempel (20) als gewölbte Fläche und der entgegengesetzten Stirnfläche (22) als ebene Fläche;

– Metallisierung der Oberflächen (21, 22, 23) der Stempel (20);

– Auflegen eines Rings (13) rund um jede Diode (10) und Auflöten der Ringe mit ihrer metallisierten Endfläche (17) auf die gemeinsame Platte (12);

– Einführung der n Stempel in die n Ringe (13), derart, dass die metallisierten gewölbten Stirnflächen (23) die Dioden (10) berühren;

– dichtes Verschliessen der Zwischenräume zwischen den Stempeln (20) und den Ringen (13) mit einem wärmehärtenden Harz (27);

– Zerschneiden der Platte (12) in individuelle Plättchen (24), die je eine Diode (10) umgeben von einem Ring (13) und kontaktiert von einem Stempel (20) tragen;

– Aufbringen jedes Plättchens (24) durch Löten auf einen metallischen Träger (26).

2. Verfahren nach Anspruch 1, dadurch gekennzeichnet, dass der Stempel (20) aus einem Stück Draht aus einem elektrisch gut leitenden Metall besteht.

3. Verfahren nach Anspruch 1, dadurch gekennzeichnet, dass der Stempel (20) ein metallisiertes Stück Glasfaser ist.

4. Verfahren nach Anspruch 1, dadurch gekennzeichnet, dass der Ring (13) aus einem kurzen Glasröhrchen besteht.

5. Verfahren nach Anspruch 4, dadurch gekennzeichnet, dass das Glas eine Dielektrizitätskonstante ε besitzt, die dem Wert 6 gleicht oder ähnelt.

6. Verfahren nach einem beliebigen der Ansprüche 1 bis 5, dadurch gekennzeichnet, dass d1 und d2 im wesentlichen 125 μm bzw. 1000 μm betragen und dass h zwischen 1,23 und 1,8 mm für Betriebsfrequenzen um 100 GHz gewählt ist.

**Claims**

1. A method for manufacturing a semiconductor device which can be used at very high frequencies and which comprises a coaxial line with preadjustable impedance, this method including

– the manufacture of n diodes (10) which can be used at very high frequencies, on a common plate (12);

– the preparation of n cylindrical rings (13) made of a dielectric material and presenting two plane end faces (14, 15);

– the preparation of n cylindrical mandrels (20), the outer diameter (d2) of which is smaller than the inner diameter (d1) of the rings (13) and the length L of which is at least equal to the length h of the rings (13), this method being characterized in that it further comprises the following steps:

    – the metallisation (16) of the outer cylindrical wall of the rings (13) and of one end face (15);

    – the forming of a convex end face (23) on one side and a plane end face (22) on the other side of the n mandrels (20);

    – the metallisation of the surfaces (21, 22, 23) of the mandrels (20);

    – the setting down of a ring (13) around each diode (13) and soldering of the metallised face (17) of the rings to the common plate (12);

    – introduction of the n mandrels (20) into the n rings (13) by placing the convex end metallised faces (23) in contact with the diodes (10);

    – the hermetical closing of the intervals between the mandrels (20) and the rings (13) by means of a joint made of a thermohardening resin (27);

    – the cutting up of the plate (12) into individual sole-pieces (24) which bear each one diode (10) encircled by a ring (13) and placed in contact with a mandrel (20);

    – the mounting of each sole-piece (24) on a metal support by soldering.

2. A method according to claim 1, characterized in that the mandrel (20) is constituted by a piece of a metal wire which is a good electrical conductor.

3. A method according to claim 1, characterized in that the mandrel (20) is a piece of glass fibre which is metal coated.

4. A method according to claim 1, characterized in that the ring (13) is a piece of a glass tube.

5. A method according to claim 4, characterized in that the glass is of the type having a dielectric constant $\varepsilon$ which is equal or close to 6.

6. A method according to any one of claims 1 to 5, characterized in that d1 and d2 are chosen at approximately 125 $\mu$m and 1000 $\mu$m respectively, and that h is included between 1,23 and 1,8 mm for operating frequencies around 100 GHz.

Fig.1

Fig.2

Fig.3

Fig.4